(19) Europäisches Patentamt
European Patent Office
Office européen des brevets

(11) **EP 2 450 716 B1**

(12) **EUROPÄISCHE PATENTSCHRIFT**

(45) Veröffentlichungstag und Bekanntmachung des Hinweises auf die Patenterteilung:
**20.11.2019 Patentblatt 2019/47**

(51) Int Cl.:
***G01R 31/08*** *(2006.01)*      ***G01R 31/12*** *(2006.01)*
***G01S 11/16*** *(2006.01)*

(21) Anmeldenummer: **11008158.5**

(22) Anmeldetag: **08.10.2011**

(54) **Anordnung zur Entstörung von akustischen Signalen bei einer Bodenschallortung**

Assembly for eliminating noise from acoustic signals during the position determination based on sound propagation in the ground

Agencement de débruitage de signaux acoustiques lors d'une localisation basée sur la propagation du son dans le sol

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **03.11.2010 DE 102010050375**

(43) Veröffentlichungstag der Anmeldung:
**09.05.2012 Patentblatt 2012/19**

(73) Patentinhaber: **Hagenuk KMT Kabelmesstechnik GmbH**
**01471 Radeburg (DE)**

(72) Erfinder:
• **Küttner Marco**
**01159 Dresden (DE)**

• **Stephan, Marco**
**01129 Dresden (DE)**

(74) Vertreter: **Marschall, Stefan et al**
**Elbpatent**
**Marschall & Partner PartGmbB**
**Jessenstrasse 4**
**22767 Hamburg (DE)**

(56) Entgegenhaltungen:
DD-A1- 267 336      DE-A1- 2 138 108
DE-A1- 2 508 444      US-A- 3 430 136
US-A- 4 095 173      US-H- H 536

EP 2 450 716 B1

**Beschreibung**

Die Erfindung bezieht sich auf eine Anordnung zur Entstörung von akustischen Signalen bei einer Bodenschallortung zur Fehlerortung an erdverlegten elektrischen Leitungen durch Lokalisierung von sich wiederholenden Lichtbogenüberschlägen an Fehlerstellen durch angeschlossene Stoßspannungsgeräte über ortsveränderliche Empfänger, der zusätzlich zu einem Akustiksensor einem Magnetfeldsensor zur Erfassung von gleichzeitig auftretenden magnetischen Impulsen bei Lichtbogenüberschlägen aufweist.

Anordnungen dieser Art zur akustischen Nachortung sind bei einer Fehlerortung in Leitungen bekannt, wobei über eine Empfangseinheit, bestehend aus Magnetfeldsensor, akustischem Sensor und Anzeigeneinheit, eine Auswertung mit Ortung der Position von Lichtbogenüberschläge ermöglicht wird.

Der Mangel bei einer derartigen Nachortung besteht darin, daß oftmals vorhandene äußere akustische Störgeräusche auftreten, die eine exakte Bodenschallortung beeinträchtigen oder verhindern. Diese Störquellen bestehen in Umwelteinflüssen, wie Wind und Regen, Straßenverkehr und Fußgängern, welche das Nutzsignal akustisch überlagern.

Relevante Dokumente aus dem Stand der Technik sind DD 267 336 A1, US 4 095 173 A sowie US 3 430 136 A.

Die Aufgabe der Erfindung ist es, eine deutliche Verbesserung und Entstörung der aufgenommenen akustischen Signale zu schaffen, die eine Lokalisierung von Kabelfehlern durch eine Bodenschallortung bei gattungsgemäßen Anordnungen, durch Ausgabe der akustischen Signale als Audiokanal, eindeutig unter Ausschluss bzw. Reduzierung der Störeinflüsse ermöglicht. Hierbei soll ferner die Aufgabe gelöst werden, dass das Nutzsignal durch eine Störunterdrückung nicht verzerrt wird, um den akustischen Höreindruck nicht zu verfälschen.

Diese Aufgabe wird durch eine Anordnung gemäß dem unabhängigen Anspruch 1 und ein Verfahren gemäß dem unabhängigen Anspruch 5 gelöst.

Die Lösung dieser Aufgabe erfolgt erfindungsgemäß dadurch, dass die erfaßten Akustikimpulse einem Speicher zugeführt und über eine Recheneinheit durch einem Rechenalgorithmus mit einem vorherigen Akustikimpuls verrechnet und die Synchronisation der Startzeitpunkte der einzelnen Akustikimpulse durch den jeweils zugehörigen erfaßten Magnetimpuls erfolgt sowie das Ergebnis aus der Recheneinheit über den Rechenalgorithmus einer Auswerteeinheit zugeführt wird.

Hierdurch wird berücksichtigt, dass die Zeitfunktion der wiederholt auftretenden zeitlich begrenzten Akustiksignale im Verlauf einer Messung an einem Ort sich nicht wesentlich unterscheiden, während die Störsignale stochastisch auftreten. Somit ist es möglich, die zeitlich begrenzten Nutzsignale durch einen Algorithmus mit Hilfe des magnetischen Impulses als Startpunkt für die Signalverarbeitung anzuwenden und die auftretenden akustischen Störsignale im wesentlichen zu unterdrücken ohne das Nutzsignal zu verzerren.

Vorteilhafterweise ist vorgesehen, dass die Auswerteeinheit als Audiokanal ausgebildet ist.

Um eine Standortveränderung zu berücksichtigen, wird vorgeschlagen, dass ein Schalter, wie ein Bewegungsmelder und/oder ein Berührungssensor, in dem ortsveränderlichen Empfänger mit dem Akustiksensor und Magnetsensor integriert ist, welcher einen Neustart der Algorithmen in der Recheneinheit zur Entstörung der akustischen Signale nach einer Positionsveränderung ermöglicht.

Ferner wird vorgeschlagen, dass die Recheneinheit zur Entstörung der akustischen Signale eine Mittelwertermittlung als Algorithmus verwendet.

In der Zeichnung ist ein Ausführungsbeispiel der Erfindung schematisch dargestellt. Es zeigen:

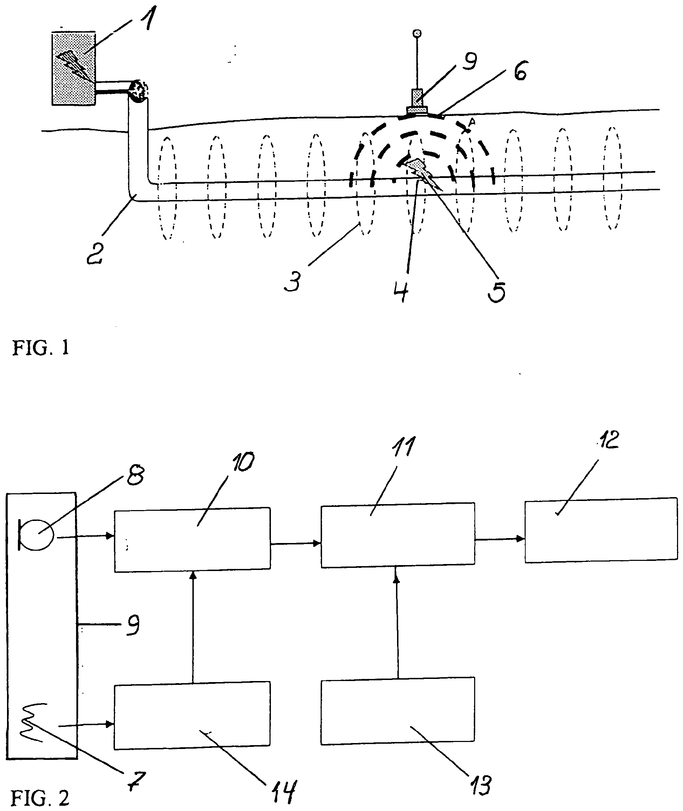

Fig. 1     einen prinzipiellen Aufbau einer akustischen Nachortung;

Fig. 2     ein Blockschaltbild für eine Entstörung durch eine Mittelwertbildung;

Fig. 3     eine Prinzipdarstellung zur Speicherung des akustischen Signals;

Fig. 4     ein Diagramm von akustischen Überschlagsbildern mit auftretenden Amplituden über die Zeit an einer Fehlerstelle mit Hilfe des magnetischen Signals als Bezugspunkt übereinander gelegte Überschlagbilder und

Fig. 5     ein Diagramm wie Fig. 4 mit Ergebnissen bei einer Mittelwertbildung mit deutlich reduzierten Störsignalen

Bei einer akustischen Nachortung ist vorgesehen, eine punktgenaue Lokalisierung von Fehlern in erdverlegten Kabeln im Gelände präzise durchzuführen.

Hierzu werden mittels eines Stoßspannungsgenerators 1 Stoßspannungsimpulse in das fehlerhafte Kabel 2 unter Ausbildung eines magnetischen Feldes 3 eingespeist, welche an einer Fehlerstelle 4 zu Lichtbogenüberschlägen 5 führen. Ein entsprechender akustischer Impuls, welcher durch jeden Lichtbogenüberschag an der Fehlerstelle entsteht, breitet sich im Erdboden aus und wird als Signal 6 an der Erdoberfläche erfaßt. Eine Empfangseinheit 9 besteht in bekannter Weise aus einem Magnetfeldsensor 7 und einem Akustiksensor 8 sowie einer nicht näher dargestellten Anzeigeeinheit. Bei der Schallortung mittels eines Akustiksensors 8 werden die Lichtbogenüberschlaggeräusche ausgewertet. Die Auswertung der Zeitdifferenz zwischen dem Eintreffen des magnetischen Signals 3 und des akustischen Signals 6 ermöglicht eine Entfernungsmessung. Die Zeitdifferenz zwischen beiden Signalen 3 und 6 verkürzt sich bei Annäherung an die Fehlerstelle 4 und endet in einem deutlichen Minimum direkt an der Fehlerstelle.

Bei dieser akustischen Nachortung werden durch das neuartige Verfahren die auftretenden Störgeräusche, die eine exakte Fehlerortbestimmung beeinträchtigen, mittels Signalverarbeitung unterdrückt. Hierbei wird berücksichtigt, dass sich die Zeitfunktionen der zeitlich begrenzten akustischen Impulse während einer Messung nicht wesentlich unterscheiden und auftretende Störgeräusche in Bezug zum Nutzsignal stochastisch auftreten. Diese Störgeräusche werden durch das Verfahren unterdrückt, wodurch eine bessere Identifizierung der Lichtbogenüberschlagsgeräusche ermöglicht wird.

Zur Entstörung der akustischen Signale 6 werden über den Akustiksensor 8 als Bodenschallmikrofon diese Signale zeitdiskretisiert und anschließend in einem Speicher 10 nacheinander abgelegt. Entscheidend hierbei ist das der Startzeitpunkt der Speicherung der akustischen Signale absolut exakt ohne Schwankungen mittels dem jeweils auftretenden magnetische Signal bestimmt wird. Die derartig gewonnenen akustischen Signale werden einer Recheneinheit 11 zur Mittelwertbildung zugeführt und einer Auswerteeinheit 12 übergeben, die in diesem Fall als Audiokanal ausgebildet ist.

Hierbei wird die Recheneinheit 11 durch ein Signal eines Bewegungsmelders 13 und/oder eines Berührungssensors der Empfangseinheit 9 bei Positionsänderung gesteuert, um eine Beendigung oder einen Neustart der Recheneinheit 11 zur Mittelwertbildung beim Umsetzen der Empfangseinheit 9 durchzuführen.

Bei dieser Signalverarbeitung ist zu berücksichtigen, dass die im Speicher 10 abgelegten akustischen Signale aus einer endlichen Anzahl A an Samples des zeitdiskreten akustischen Signals $x(k)$ mit einer Abtastperiode $T_a$ bestehen, welche letztendlich auch im Speicher 10 zwischengespeichert werden müssen.

Ein im Speicher abgelegtes akustisches Signal des n-ten Stoßimpulses, wird nachfolgend als Datenvektor $\vec{V}_n$.

$$\vec{V}_n = [x(k + nP_{stos}) \quad \ldots \quad x(k + nP_{stos} + A - 1]$$

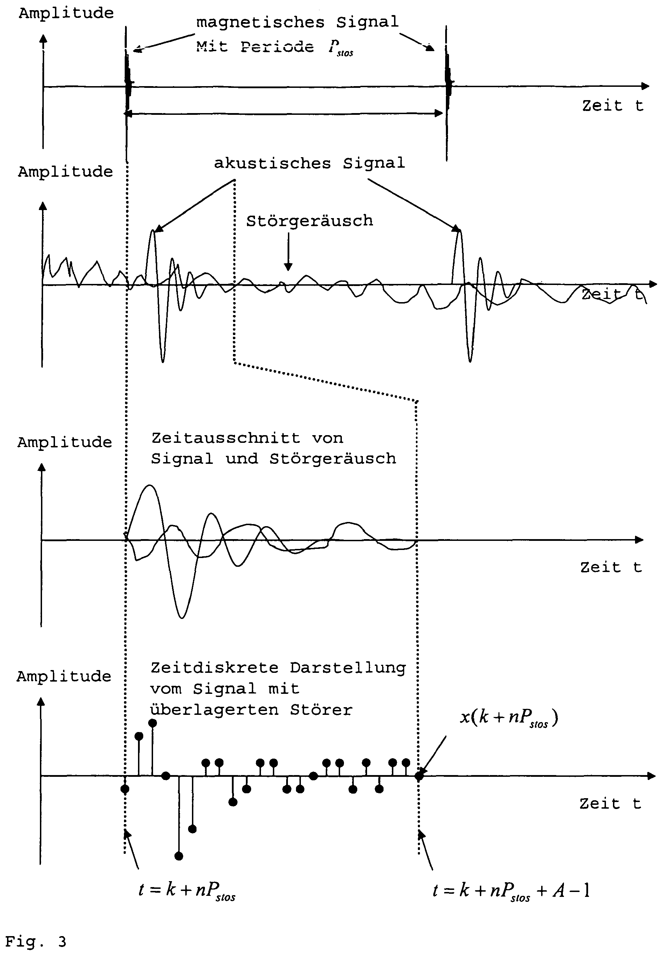

definiert, wobei $x(k+nP_{stos})$ das jeweils erste Sample und $x(k+nP_{stos}+A-1)$ das letzte Sample des n-ten gespeicherten akustischen Signals ist. Hierbei wurde angenommen, dass die eintreffenden magnetischen und akustischen Signale sich periodisch mit der Stoßperiode $P_{Stoß}$ wiederholen. Dieses ist in Fig. 3 bildlich dargestellt.

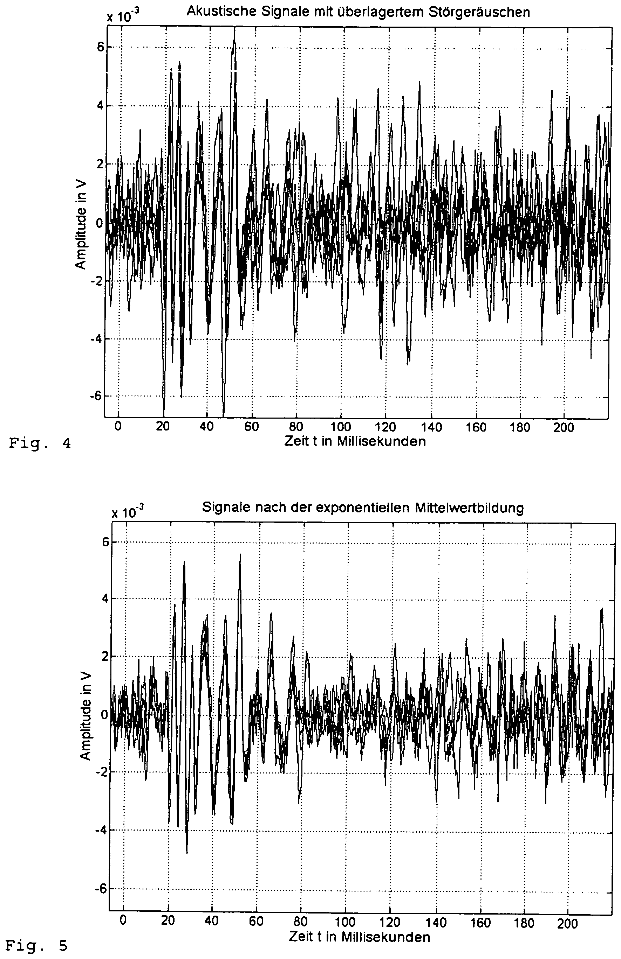

Die Verbesserung der aufgenommenen akustischen Signale (Fig.4) durch die Verwendung des beschriebenen Verfahrens ist in Fig.5 dargestellt. Deutlich erkennbar ist die Reduzierung der Störgeräusche bei Beibehaltung des Überschlaggeräusches und somit die Verbesserung der Audioqualität.

**Patentansprüche**

1. Anordnung zur Entstörung von akustischen Signalen bei einer Bodenschallortung zur Fehlerortung an erdverlegten elektrischen Leitungen durch Lokalisierung von sich wiederholenden Lichtbogenüberschlägen an Fehlerstellen durch ein angeschlossenes Stoßspannungsgerät,
   wobei die Anordnung einen ortsveränderlichen Empfänger (9) mit einem Akustiksensor (8) und einem Magnetfeldsensor (7) zur Erfassung von gleichzeitig auftretenden magnetischen Impulsen bei Lichtbogenüberschlägen, einen Speicher (10), eine Recheneinheit (11) und eine Auswerteeinheit (12) umfasst,
   **dadurch gekennzeichnet,**
   **dass** die Anordnung dazu eingerichtet ist, die erfassten Akustikimpulse (6) dem Speicher (10) zuzuführen sowie in der Recheneinheit (11) durch einen Rechenalgorithmus mit einem oder mehreren vorherigen Akustikimpulsen (6) zu verrechnen, wobei die Synchronisation der Startzeitpunkte der einzelnen Akustikimpulse (6) durch den jeweils zugehörigen erfassten Magnetimpuls (7) erfolgt und das Ergebnis aus der Recheneinheit (10) über den Rechenalgorithmus der Auswerteeinheit (12) zugeführt wird,
   und wobei die Recheneinheit (11) dazu eingerichtet ist, zur Entstörung der akustischen Signale eine Mittelwertbildung als Algorithmus zu verwenden.

2. Anordnung nach Anspruch 1, **dadurch gekennzeichnet, dass** die Auswerteeinheit (12) als Audiokanal ausgebildet ist.

3. Anordnung nach Anspruch 1 oder 2, **dadurch gekennzeichnet, dass** der ortsveränderliche Empfänger (9) einen Schalter, wie einen Bewegungsmelder (13), umfasst, der dazu eingerichtet ist, eine Positionsveränderung des Empfängers (9) zu signalisieren, wobei mit dem Schalter ein Neustart der Algorithmen in der Recheneinheit (11) zur Entstörung der akustischen Signale einstellbar ist.

4.  Anordnung nach Anspruch 1 oder 2, **dadurch gekennzeichnet, dass** der Empfänger (9) einen Schalter, wie einen Berührungssensor, umfasst, wobei mit dem Schalter ein Neustart der Algorithmen in der Recheneinheit (11) zur Entstörung der akustischen Signale einstellbar ist.

5.  Verfahren zur Entstörung von akustischen Signalen bei einer Bodenschallortung zur Fehlerortung an erdverlegten elektrischen Leitungen durch Lokalisierung von sich wiederholenden Lichtbogenüberschlägen an Fehlerstellen durch ein angeschlossenes Stoßspannungsgerät über einen ortsveränderlichen Empfänger (9), der zusätzlich zu einem Akustiksensor (8) einen Magnetfeldsensor (7) zur Erfassung von gleichzeitig auftretenden magnetischen Impulsen bei Lichtbogenüberschlägen aufweist,
    **dadurch gekennzeichnet, dass**
    die erfassten Akustikimpulse (6) einem Speicher (10) zugeführt und über eine Recheneinheit (11) durch einen Rechenalgorithmus mit einem oder mehreren vorherigen Akustikimpulsen (6) verrechnet werden, wobei eine Synchronisation der Startzeitpunkte der einzelnen Akustikimpulse (6) durch den jeweils zugehörigen erfassten Magnetimpuls (7) erfolgt und das Ergebnis aus der Recheneinheit (10) über den Rechenalgorithmus einer Auswerteeinheit (12) zugeführt wird,
    und wobei die Recheneinheit (11) zur Entstörung der akustischen Signale eine Mittelwertbildung als Algorithmus verwendet.

## Claims

1.  An arrangement for suppressing interference of acoustic signals during ground sound location for locating faults in buried electrical lines by localizing repeating arc overs at fault sites by means of a connected impulse voltage device, the arrangement comprising a mobile receiver (9) having an acoustic sensor (8) and a magnetic field sensor (7) for detecting simultaneously occurring magnetic pulses in the event of arc overs, a memory (10), an arithmetic logic unit (11) and an evaluation unit (12),
    **characterized**
    **in that** the arrangement is set up to supply the detected acoustic pulses (6) to the memory (10) and offset the same with one or more previous acoustic pulses (6) in the arithmetic logic unit (11) by means of a computing algorithm, wherein the synchronization of the start times of the individual acoustic pulses (6) takes place by means of the respectively associated detected magnetic pulse (7) and the result from the arithmetic logic unit (10) is supplied via the computing algorithm to the evaluation unit (12),
    and wherein the arithmetic logic unit (11) is set up to use an averaging as algorithm for suppressing interference of the acoustic signals.

2.  The device according to Claim 1, **characterized in that** the evaluation unit (12) is constructed as an audio channel.

3.  The arrangement according to Claim 1 or 2, **characterized in that** the mobile receiver (9) comprises a switch, such as a motion detector (13), which is set up to signal a change in position of the receiver (9), wherein a restart of the algorithms in the arithmetic logic unit (11) can be set up using the switch for suppressing interference of the acoustic signals.

4.  The arrangement according to Claim 1 or 2, **characterized in that** the receiver (9) comprises a switch, such as a contact sensor, wherein a restart of the algorithms in the arithmetic logic unit (11) can be set up using the switch for suppressing interference of the acoustic signals.

5.  A method for suppressing interference of acoustic signals during ground sound location for locating faults in buried electrical lines by localizing repeating arc overs at fault sites by means of a connected impulse voltage device, via a mobile receiver (9), which in addition to an acoustic sensor (8), has a magnetic field sensor (7) for detecting simultaneously occurring magnetic pulses in the event of arc overs,
    **characterized in that**
    the detected acoustic pulses (6) are supplied to a memory (10) and offset with one or more previous acoustic pulses (6) via an arithmetic logic unit (11) by means of a computing algorithm, wherein a synchronization of the start times of the individual acoustic pulses (6) takes place by means of the respectively associated detected magnetic pulse (7) and the result from the arithmetic logic unit (10) is supplied via the computing algorithm to an evaluation unit (12), and wherein the arithmetic logic unit (11) uses an averaging as algorithm for suppressing interference of the acoustic signals.

**Revendications**

1. Système de déparasitage de signaux acoustiques lors d'une localisation acoustique dans le sol pour la localisation de défauts sur des lignes électriques enterrées par localisation de décharges d'arc électrique aux points de défaut par un appareil à tension de choc raccordé,
sachant que le système comprend un récepteur mobile (9) avec un capteur acoustique (8) et un capteur de champ magnétique (7) pour la saisie d'impulsions magnétiques se produisant simultanément lors de décharges d'arc électrique, une mémoire (10), une unité de calcul (11) et une unité d'exploitation (12),
**caractérisé**
**en ce que** le système est agencé pour acheminer les impulsions acoustiques saisies (6) à la mémoire (10) ainsi que pour compenser dans l'unité de calcul (11) grâce à un algorithme de calcul par une ou plusieurs impulsions acoustiques précédentes (6), sachant que la synchronisation des moments de démarrage des impulsions acoustiques individuelles (6) a lieu par l'impulsion magnétique (7) respectivement saisie correspondante et le résultat venant de l'unité de calcul (10) est acheminée à une unité d'exploitation (12) par le biais de l'algorithme de calcul, et sachant que l'unité de calcul (11) est agencée à cet effet pour utiliser une formation de moyenne comme algorithme pour le déparasitage des signaux acoustiques

2. Système selon la revendication 1, **caractérisé en ce que** l'unité d'exploitation (12) est constitué comme un canal audio.

3. Système selon la revendication 1 ou 2, **caractérisé en ce que** le récepteur mobile (9) comprend un contacteur, comme un détecteur de mouvement (13), qui est agencé pour signaler une modification de position du récepteur (9), sachant qu'une réinitialisation des algorithmes dans l'unité de calcul (11) peut être réglée avec le contacteur pour le déparasitage des signaux acoustiques.

4. Système selon la revendication 1 ou 2, **caractérisé en ce que** le récepteur (9) comprend un contacteur, comme un capteur de contact, sachant qu'une réinitialisation des algorithmes dans l'unité de calcul (11) peut être réglée avec le contacteur pour le déparasitage des signaux acoustiques.

5. Procédé de déparasitage de signaux acoustiques lors d'une localisation acoustique dans le sol pour la localisation de défauts sur des lignes électriques enterrées par localisation de décharges d'arc électrique se répétant aux points de défaut par un appareil à tension de choc raccordé par le biais d'un récepteur mobile (9), qui comporte en plus d'un capteur acoustique (8), un capteur de champ magnétique (7) pour la saisie d'impulsions magnétiques se produisant simultanément lors de décharges d'arc électrique,
**caractérisé en ce que**
les impulsions acoustiques saisies (6) sont acheminées à une mémoire (10) et compensées par une ou plusieurs impulsions acoustiques précédentes (6) grâce à un algorithme de calcul par le biais d'une unité de calcul (11), sachant qu'une synchronisation des moments de démarrage des impulsions acoustiques individuelles (6) a lieu par l'impulsion magnétique (7) saisie respectivement correspondante et le résultat venant de l'unité de calcul (10) est acheminée à une unité d'exploitation (12) par le biais de l'algorithme de calcul, et sachant que l'unité de calcul (11) utilise une formation de moyenne en tant qu'algorithme pour le déparasitage des signaux acoustiques.

FIG. 1

FIG. 2

Fig. 4

Fig. 5

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DD 267336 A1
- US 4095173 A
- US 3430136 A